# EUROPÄISCHE PATENTSCHRIFT

(11) **EP 0 491 692 B1**
(45) Veröffentlichungstag und Bekanntmachung des Hinweises auf die Patenterteilung: **16.06.1993**
(21) Anmeldenummer: 90905478.5
(22) Anmeldetag: 06.04.1990
(51) Int. Cl.: H05B 39/08, H03K 17/96

(54) **SCHALTUNG ZUM KOMPENSIEREN DES KAPAZITIVEN EINFLUSSES EINER SEKUNDÄRSEITIGEN ANSCHLUSSLEITUNG EINER NIEDERSPANNUNGSLAMPE**
CIRCUIT FOR COMPENSATING THE CAPACITIVE EFFECT OF A CONNECTION OF A LOW-VOLTAGE LAMP ON THE SECONDARY SIDE
CIRCUIT COMPENSATEUR DE L'INFLUENCE CAPACITIVE DE LA LIGNE DE RACCORDEMENT DU C TE SECONDAIRE D'UNE LAMPE A BASSE TENSION

(30) Priorität: 13.09.1989 DE 3930618
(43) Veröffentlichungstag der Anmeldung: 01.07.1992
(73) Patentinhaber: MAURER, Ingo, D-80801 München (DE)
(72) Erfinder: KOWATSCH, Hermann, W-8911 Windach (DE)
(74) Vertreter: Schoppe, Fritz, Dipl.-Ing.
(86) Internationale Anmeldenummer: EP9000545
(87) Internationale Veröffentlichungsnummer: WO9104648

(56) Entgegenhaltungen:
- WO-A-89/04110
- DE-A- 2 806 112
- US-A- 4 701 676
- US-A- 4 764 708

## Beschreibung

Die vorliegende Erfindung betrifft eine Schaltung zum Betreiben einer über einen Transformator angeschlossenen Niederspannunglampe und zum Ein/Aus-Schalten und/oder Dimmen der Lampe, welche auf eine kurzfristige oder längerfristige Amplitudenveränderung einer Eingangswechselspannung anspricht, die durch kurzfristiges oder längerfristiges Berühren der Anschlußleitung zum Zwecke des Ein/Aus-Schaltens oder des Dimmens der Niederspannungslampe erzeugbar ist.

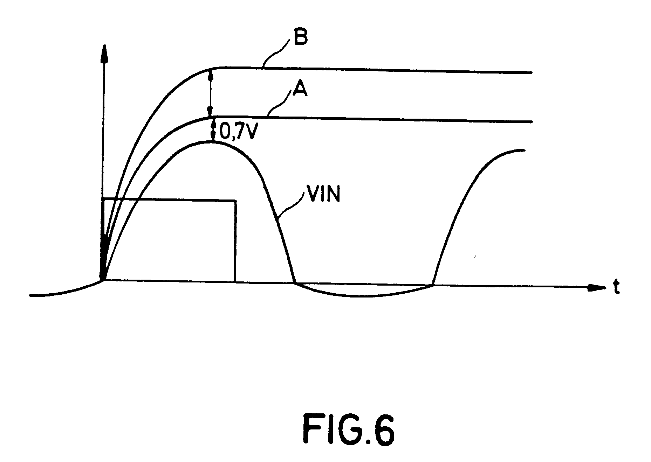

Aus der US-A 4,764,708 ist es bereits bekannt, zur Kompensation von kapazitiven Schwankungen des berührungsempfindlichen Teiles einer Netzspannungsschaltung eine Kompensationsschaltung einzusetzen, die mit zwei verschiedenen Kondensatorschaltungen arbeitet, welche einerseits eine kleine Zeitkonstante für einen berührungsempfindlichen Schaltungsteil (Fig. 5, Bez. Zchn. 72) und andererseits eine große Zeitkonstante für einen Umgebungskapazitäts-empfindlichen Schaltungsteil (Fig. 5, Bez. Zchn. 70) festlegen. Mittels dieser beiden Zeitkonstanten ergibt sich bei Berührung der Hochspannungslampe ein unterschiedlich schnelles Ansprechen, das zum Durchschalten der Lampe führt.

Es handelt sich also beim Gegenstand dieser Entgegenhaltung nicht um eine Schaltung zum Kompensieren des Einflusses einer sekundärseitigen Anschlußleitung einer Niederspannungslampe, sondern um eine Kompensationsschaltung für Netzspannungslampen. Ferner befaßt sich diese Entgegenhaltung nicht mit einer solchen Schaltung, die in Abhängigkeit von der Berührdauer entweder ein Ein/Aus-Schalten oder ein Dimmen der Lampe ermöglicht.

Darüber hinaus zeigt diese Schrift auch keine Einschaltsignalerzeugungsschaltung und somit logischerweise auch keine hierauf ansprechende zweite Steuerschaltung, die nur bei Vorliegen eines Einschaltsignales den zweiten Kondensator auf eine Spannung lädt, die von der ersten Kondensatorspannung abhängt.

Eine Schaltungsanordnung zum Steuern der Helligkeit einer Lampe und zum Ein/Aus-Schalten derselben durch Berühren einer sekundärseitigen Anschlußleitung ist bereits aus der deutschen Patenschrift DE-A 3,736,222 bekannt.

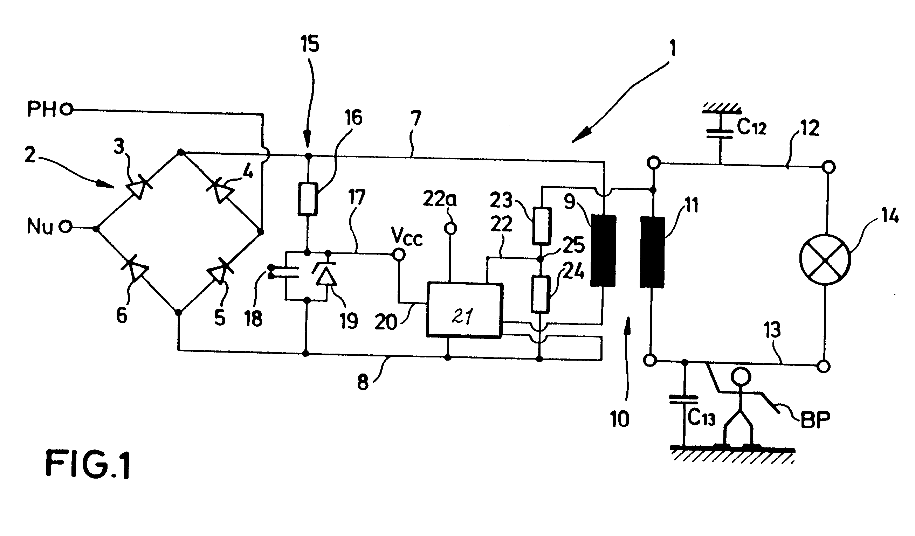

Zur Verdeutlichung des Anwendungsgebietes der vorliegenden Erfindung wird eine vereinfachte Prinzipschaltung nachfolgend unter Bezugnahme auf Fig. 1 näher erläutert, die eine Lampensteuerschaltung für Niederspannungslampen zeigt, die zum Ein/Aus-Schalten und Dimmen der Niederspannunglampe dient. Bei dieser Lampensteuerschaltung kann eine Bedienungsperson durch kurzfristiges oder längerfristiges Berühren einer Anschlußleitung einen Schaltvorgang oder einen Dimmvorgang für die Niederspannungslampe herbeiführen. Diese Lampensteuerschaltung, die in Fig. 1 in ihrer Gesamtheit mit dem Bezugszeichen 1 bezeichnet ist, umfaßt eine Gleichrichterschaltung 2 mit vier Gleichrichterelementen oder Dioden 3, 4, 5, 6, die eingangsseitig an einen Nulleiter NU und an einen Phasenleiter PH angeschlossen sind und ausgangsseitig über eine erste und zweite primärseitige Anschlußleitung 7, 8 mit der primärseitigen Wicklung 9 eines Transformators 10 verbunden sind. Eine sekundärseitige Wicklung 11 des Transformators 10 steht über eine erste und eine zweite sekundärseitige Anschlußleitung 12, 13 mit einer Niederspannungslampe 14, die üblicherweise eine Halogenlampe ist, in Verbindung. Eine Versorungsspannungserzeugungsschaltung, die in ihrer Gesamtheit mit dem Bezugszeichen 15 bezeichnet ist, liegt zwischen der ersten primärseitigen Anschlußleitung 7 und der zweiten primärseitigen Anschlußleitung 8 und umfaßt einen Vorwiderstand 16 zwischen der ersten primärseitigen Anschlußleitung 7 und einer Anschlußklemme 17 für die Versorgungsspannung Vcc, wobei die Anschlußklemme 17 über die Parallelschaltung aus einem Glättungskondensator 18 und einer Zenerdiode 19 an der zweiten primärseitigen Anschlußleitung 8 angeschlossen ist. Die Anschlußklemme 17 der Versorgungsspanungserzeugungsschaltung 15 steht mit einer Versorgungsspannungseingangsklemme 20 eines Lampenschalt- und Dimmschaltkreises 21 in Verbindung, der in die zweite primärseitige Anschlußleitung 8 eingeschaltet ist. Eine Eingangssteuerklemme 22 dieses Lampenschalt- und Dimmschaltkreises 21 liegt am gemeinsamen Knoten zweier Widerstände einer Spannungsteilerschaltung 23, 24, die einerseits mit der ersten sekundärseitigen Anschußleitung 12 und andererseits mit der zweiten primärseitigen Anschlußleitung 8 in Verbindung steht. Die Widerstände des Spannungsteilers 23, 24 sind sehr hochohmig, so daß über diese bei einer nachfolgend noch näher erläuterten Schaltoperation nur ein sehr geringer Strom von beispielsweisen 200 Microampere fließen kann. Der Lampenschalt- und Dimmerschaltkreis 21, der in seiner Struktur in der eingangs genannten Patentanmeldung des Anmelders näher erläutert ist, besteht beispielsweise aus einer integrierten Schaltung, wie sie im Handel unter der Bezeichnung S 576 A von der Firma Siemens erhältlich ist, welcher ausgangsseitig eine Phasenanschnittssteuerschaltung folgt, durch die der Mittelwert des durch die primärseitige Wicklung 9 fließenden Erregerstromes steuerbar ist.

Nachfolgend wird die Funktionsweise der in Fig. 1 gezeigten Lampensteuerschaltung 1 näher erläutert. Für den Fachmann ist es offensichtlich, daß an der ersten primärseitigen Anschlußleitung 7 lediglich die positiven Halbwellen eines eingangsseitigen Sinussignales zwischem dem Phasenleiter PH und dem Nulleiter NU anliegen, während an der zweiten primärseitigen Anschlußleitung 8 nur die negativen Halbwellen der Netzspannung anliegen, so daß die über die primärseitige Wicklung 9 abfallende Spannung die Form einer gleichgerichteten, jedoch ungeglätteten Sinusspannung hat. Diese wird sekundärseitig auf eine Niederspannung herabtransformiert, die zur Spannungsversorgung der Niederspannungslampe 14 dient. Solange die sekundärseitigen Anschlußleitungen 12, 13 von einer Bedienungsperson BP nicht berührt werden, kann kein Strom über den Spannungsteiler 23, 24 in die sekundärseitige Schaltung 11 - 14 fliegen, so daß ein Spannungsabfall an dem Spannungsteiler 23, 24 nicht auftreten kann. Sobald jedoch die Bedienungsperson BP durch Berühren einer der sekundärseitigen Anschlußleitungen 12, 13 einen Stromkreis herstellt, so liegt über den Spannungsteiler 23, 24 eine Spannung an, die unter Vernachlässigung der sekundärseitigen Spannung über die sekundärseitige Wicklung 11 und des Spannungsabfalles über die Bedienungsperson BP im wesentlichen der negativen Halbwellenspannung entspricht, die an der zweiten primärseitigen Anschlußleitung 8 liegt.

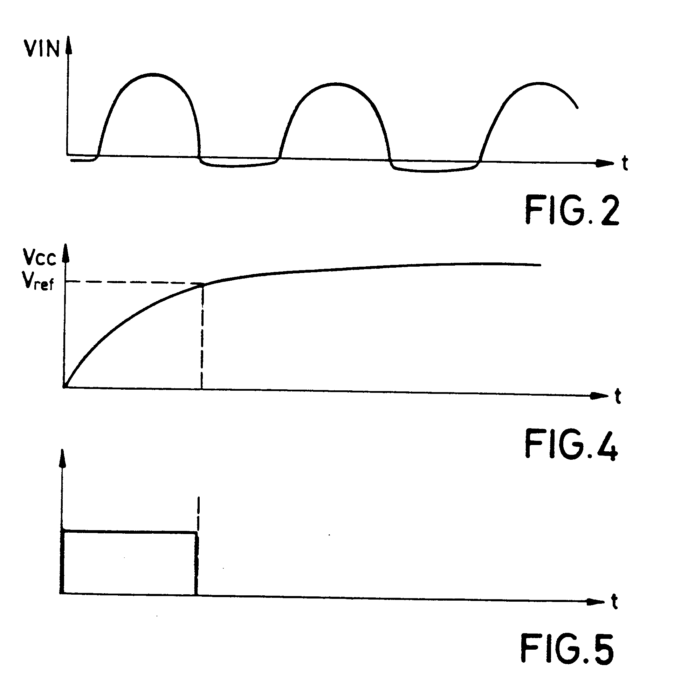

Der zeitliche Verlauf der an der Eingangssteuerklemme 22 des Lampenschalt- und Dimmschaltkreises 21 anliegenden Eingangssteuerspannung bezogen auf das Potential an der zweiten primärseitigen Anschlußleitung 8 bei Berührung durch eine Bedienungsperson BP ist schemenhaft in Fig. 2 dargestellt.

Die obige Beschreibung der Funktionsweise dieser Schaltung gilt nur unter Annahme idealer Verhältnisse. Bei praktischen Ausführungen der Lampensteuerschaltungen haben die sekundärseitigen Anschlußleitungen 12, 13 oft eine erhebliche Länge, die bei Verlegung dieser sekundärseitigen Anschlußleitungen 12, 13 in der Nähe von Wänden oder leitfähigen Körpern zu derartigen parasitären Kabelkapazitäten C₁₂, C₁₃ führt, daß diese bei dem in Rede stehenden Frequenzbereich, nämlich der doppelten Netzfrequenz und den Vielfachen der doppelten Netzfrequenz einen erheblichen kapazitiven Nebenschluß erzeugen , der zu einem Blindstrom durch den Spannungsteiler 23, 24 auch dann führt, wenn die Bedienungsperson BP nicht die sekundärseitigen Anschlußleitungen 12, 13 zum Zwecke des Herbeiführens eines Schaltvorganges oder Dimmvorganges berührt. Da der Arbeitspunkt des Lampenschalt- und Dimmschaltkreises 21 wiederum so niedrig eingestellt sein muß, daß auch eine Berührung einer sekundärseitigen Anschlußleitung 12, 13 durch eine Bedienungsperson BP mit schlechtem Kontakt detektiert wird, erweist es sich als schwierig, derartige Lampensteuerschaltungen so auszulegen, daß sie einerseits nicht unerwünscht durch kapazitive Wirkungen sekundärseitiger Anschlußleitungen ansprechen, jedoch andererseits auch eine Berührung durch eine schlecht kontaktierende Bedienungsperson BP erfassen.

Daher liegt der vorliegenden Erfindung die Aufgabe zugrunde, eine Schaltung zum kompensieren des kapazitiven Einflusses einer sekundärseitigen Anschlußleitung einer Niederspannungslampe auf das Schaltverhalten einer Lampensteuerschaltung zum Ein/Aus-Schalten und/oder Dimmen derselben, welche auf eine kurzfristige oder längerfristige Amplitudenverändetung einer Eingangs wechselspannung anspricht, die durch kurzfristiges oder längerfristiges Berühren der Anschlußleitungen zum Ein/Aus-Schalten oder Dimmen erzeugbar ist, zu schaffen.

Diese Aufgabe wird durch eine Schaltung gemäß Patentanspruch 1 gelöst.

Die Erfindung geht von der Erkenntnis aus, daß der im Stand der Technik unternommene Versuch der Dimensionierung einer Lampensteuerschaltung für Niederspannungslampen mit einem einheitlichen Arbeitspunkt scheitern muß, solange man sich nicht einer selbstlernfähigen Kompensationsschaltung bedient, die die von der jeweiligen Aufstellung der betreffenden Niederspannungslampe abhängige Größe eines kapazitiven Einflusses der sekundärseitigen Anschlußleitungen jeweils neu erfaßt und sich selbsttätig ihren Arbeitspunkt nach Abschluß dieses Lernvorganges festlegt. Ausgehend von dieser Grunderkenntnis zieht die Erfindung ferner in Betracht, daß die Verwendung selbstlernfähiger Meßschaltungen auf digitaler Basis, die sich beispielsweise eines Microcomputers bedienen, aus Kostenüberlegungen und Platzgründen für den vorliegenden Fall ausscheidet. Die Erfindung bedient sich eines ersten Kondensators, der über eine erste Steuerschaltung auf eine von dem jeweiligen Spitzenwert der Eingangswechselspannung abhängige Kondensatorspannung aufladbar ist. Eine Einschaltsignalerzeugungsschaltung erzeugt ein Einschaltsignal während einer bestimmten Zeitdauer ab dem jeweiligen Einschalten der Versorgungsspannung der Niederspannungslampe. Eine zweite Steuerschaltung spricht auf das von der Einschaltsignalerzeugungsschaltung generierte Einschaltsignal an und lädt bei dessen Vorliegen einen zweiten Kondensator auf eine von der ersten Kondensatorspannung abhängige zweite Kondensatorspannung auf. Eine mit den beiden Kondensatoren eingangsseitig verbundene erste Vergleicherschaltung aktiviert nur dann die Lampensteuerschaltung durch Zuführen eines Signales zu dieser, wenn die erste Kondensatorspannung einen von der zweiten Kondensatorspannung abhängigen Spannungswert überschreitet. Die erfindungsgemäße Kompensationsschaltung kann ohne weitere Veränderungen der oben beschriebenen Lampensteuerschaltung zwischen dem Knoten des Spannungsteilers 23, 24 und der Eingangssteuerklemme 22 des Lampenschalt- und Dimmschaltkreises 21 eingeschaltet werden.

Bevorzugte Weiterbildungen und Ausgestaltungen der vorliegenden Erfindung sind in den Unteransprüchen angegeben.

Nachfolgend wird unter Bezugnahme auf die beiliegenden Zeichnungen eine bevorzugte Ausführungsform der erfindungsgemäßen Schaltung näher erläutert. Es zeigen:
- Fig. 1: eine Ausführungsform einer eingangs beschriebenen Lampensteuerschaltung;
- Fig. 2: ein Eingangssignal eines Lampenschalt- und Dimmerschaltkreises bei der Schaltung gemäß Fig. 1, welches am Knoten eines Spannungsteilers derselben auftritt;
- Fig. 3a, 3b,: eine bevorzugte Ausführungsform der erfindungsgemäßen Schaltung zum Kompensieren des kapazitiven Einflusses sekundärseitiger Anschlußleitungen auf das Schaltverhalten der Lampensteuerschaltung; und
- Fig. 4 bis 6: zeitabhängige Spannungsverläufe zum Erläutern der Funktionsweise der erfindungsgemäßen Schaltung.

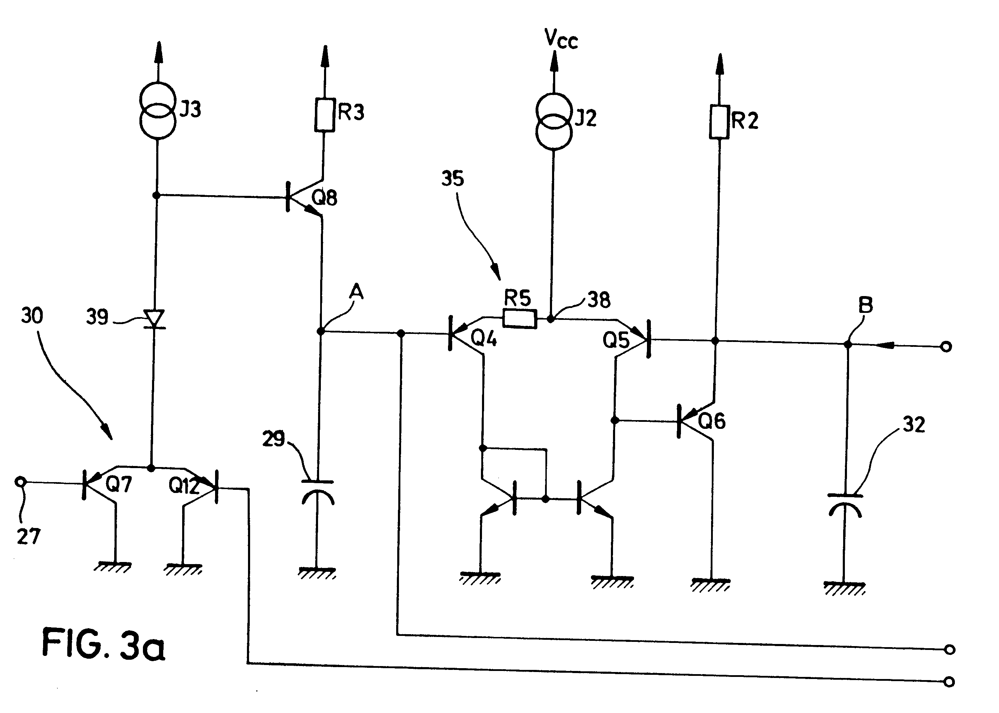

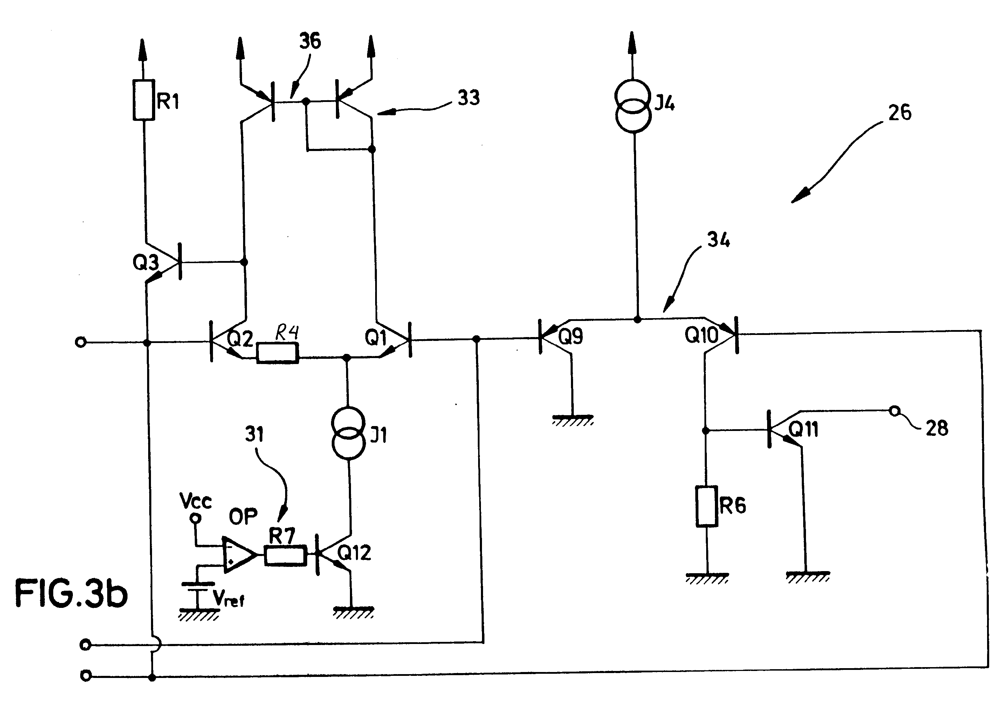

Nachfolgend wird unter Bezugnahme auf die Fig. 3a und 3b eine bevorzugte und praktisch realiserte Ausführungsform der erfindungsgemäßen Schaltung zum Kompensieren des kapazitiven Einflusses von sekundärseitigen Anschlußleitungen einer Niederspannungslampe auf das Schaltverhalten einer Lampensteuerschaltung zum Ein/Aus-Schalten und/oder Dimmen derselben näher erläutert, die in ihrer Gesamtheit mit dem Bezugszeichen 26 bezeichnet ist. Ein Eingang 27 dieser Kompensationsschaltung 26 liegt beispielsweise an einem Knotenpunkt 25 des Spannungsteilers 23, 24 gemäß Fig. 1, während ein Ausgang 28 mit einer auf digitale Signale ansprechende Eingangssteuerklemme 22a des Lampenschalt- und Dimmschaltkreises 21 bzw. der Lampensteuerschaltung verbunden ist.

Die erfindungsgemäße Kompensationsschaltung umfaßt einen ersten Kondensator 29, der über eine erste Steuerschaltung 30 auf eine von dem jeweiligen Spitzenwert der Eingangswechselspannung abhängige erste Kondensatorspannung aufladbar ist, eine Einschaltsignalerzeugungsschaltung 31 zum Erzeugen eines Einschaltsignales während einer bestimmten Zeitdauer ab Einschalten der Versorgungsspannung Vcc der Nieder spannungslampe 14 (Fig. 1), einen zweiten Kondensator 32, eine zweite Steuerschaltung 33, die auf das Einschaltsignal von der Einschaltsignalerzeugungsschaltung 31 anspricht, und durch die der zweite Kondensator 32 bei Vorliegen des Einschaltsignales auf eine von der ersten Kondensatorspannung abhängige zweite Kondensatorspannung aufladbar ist, sowie eine erste Vergleicherschaltung 34, die eingangsseitig mit dem ersten und zweiten Kondensator 29, 32 und ausgangsseitig mit der Eingangsklemme 22a des Lampenschalt- und Dimmschaltkreises 21 in Wirkverbindung steht und die dem Lampenschalt- und Dimmschaltkreis 21 ein das Schalten oder Dimmen der Niederspannungslampe 14 durch diese bewirkendes Signal zuführt, wenn die erste Kondensatorspannung einen von der zweiten Kondensatorspannung abhängigen Spannungswert überschreitet. Eine dritte Steuerschaltung 35 dient zum Regeln der Ladung des zweiten Kondensators 32 und ist mit dem ersten Kondensator 29 und dem zweiten Kondensator 32 verbunden. Die zweite Steuerschaltung 33 umfaßt einen ersten und einen zweiten Transistor Q1, Q2, die kollektorseitig jeweils mit Ausgängen einer ersten Stromspiegelschaltung 36 verbunden sind. Der erste Transistor Q1 liegt emitterseitig direkt an einem ersten gemeinsamen Knoten, mit dem der zweite Transistor Q2 über einen vierten Widerstand R4 verbunden ist. An diesen Knoten ist eine erste Stromquelle I1 angeschlossen, die an den Kollektor eines zwölften Transistors Q12 angeschlossen ist, der emitterseitig an Masse liegt und basisseitig über einen siebten Widerstand R7 mit dem Ausgang eines Operationsverstärkers OP verbunden ist, dem an seinem invertierenden Eingang die Versorgungsspannung Vcc und an seinem nicht-invertierenden Eingang eine Bezugsspannungsquelle Vref zugeführt wird, welche etwa 70 % der Versorgungsspannung Vcc beträgt.

Der ersten Transistor Q1 liegt basisseitig an dem ersten Kondensator 29, während der zweite Transistor Q2 basisseitig an dem zweiten Kondensator 32 liegt.

Die zweite Steuerschaltung 33 umfaßt ferner einen dritten Transistor Q3, dessen Basis mit dem Kollektor des zweiten Transistors Q2 und dessen Emitter mit der Basis des zweiten Transistors Q2 und dessen Kollektor über einen ersten Widerstand R1 mit der Versorgungsspannung Vcc in Verbindung stehen.

Die dritte Steuerschaltung 35 umfaßt einen vierten und fünften Transistor Q4, Q5. Der vierten Transistor Q4 ist basisseitig mit dem ersten Kondensator 29 verbunden. Der fünfte Transistor Q5 liegt mit seiner Basis an dem zweiten Kondensator 32. Der vierte Transistor und der fünfte Transistor liegen kollektorseitig an Stromeingängen einer zweiten Stromspiegelschaltung 37, die ebenso wie die erste Stromspiegelschaltung 36 ein Stromverhältnis von 1 : 1 festlegt. Ein fünfter Widerstand R5 liegt zwischen dem Emitter des vierten Transistors und eine zweiten Knoten 38, an den der Emitter des fünften Transistors und eine zweite Stromquelle 12 angeschlossen sind. Ein sechster Transistor Q6 liegt kollektorseitig an Masse, ist emitterseitig mit der Basis des fünften Transistors Q5 und basisseitig mit dessen Kollektor verbunden. Zwischen der Basis des fünften Transistors Q5 und der Versorgungsspannung liegt ein zweiter Widerstand R2. Der Widerstandswert des zweiten Widerstandes R2 ist hochohmig gegenüber dem Widerstand des ersten Widerstandes R1 der zweiten Steuerschaltung 33.

Die erste Steuerschaltung 30 umfaßt einen siebten Transistor Q7, der basisseitig an den Eingang 27, kollektorseitig an Masse und emitterseitig über eine Diode 39 an die Basis eines achten Transistors Q8 angeschlossen ist, dessen Basis gleichfalls über eine dritte Stromquelle I3 mit der Versorgungsspannung in Verbindung steht. Der Kollektor des achten Transistors Q8 steht über einen dritten Widerstand R3 mit der Versorgungsspannung Vcc in Verbindung. Der Emitter des achten Transistors Q8 ist mit dem ersten Kondensator 29 verbunden.

Die erste Vergleicherschaltung 34 umfaßt einen neunten Transistor Q9, der basisseitig an den ersten Kondensator 29, kollektorseitig mit Masse und emitterseitig mit einer vierten Stromquelle I4 verbunden ist, sowie einen zehnten Transistor Q10, der emitterseitig gleichfalls mit der vierten Stromquelle I4, basisseitig mit dem zweiten Kondensator 32 und kollektorseitig mit der Basis eines elften Transistors Q11 sowie einem gegen Masse geschalteten sechsten Widerstand R6 verbunden ist. Der elfte Transistor Q11 ist mit seinem Kollektor an den Ausgang 28 der Kompensationsschaltung 26 angeschlossen und liegt emitterseitig an Masse.

Der Widerstandswert des vierten und fünften Widerstandes sind gleich.

Ein Zwölfter Transistor Q12 liegt emitterseitig an dem Emitter des siebten Transistors Q7, basisseitig an dem zweiten Kondensator 32 und kollektorseitig an Masse.

Nachfolgend wird die Funktionsweise der in den Fig. 3a, 3b gezeigten Kompensationsschaltung 26 erläutert.

Eine an dem Eingang 27 der in Fig. 3 gezeigten Kompensationsschaltung 26 anliegende Eingangswechselspannung erscheint aufgrund der jeweiligen Spannungsabfälle über die Basisemitterstrecke des siebten und achten Transistors Q7, Q8 sowie über die Diode 39 mit einer Differenzspannung von etwa + 0,7 Volt oberhalb des Spitzenwertes der am Eingang 27 anliegenden Spannung an dem ersten Kondensator 29. Der Verlauf der Spannung am Punkt A in Fig. 3 ist gleichfalls in Fig. 6 zu sehen.

Wie für den Fachmann aus der Prinzipschaltung von Fig. 1 zu sehen ist, steigt bei Einschalten der Netzspannung die Versorgungsspannung Vcc mit dem Aufladen des Kondensators 18 exponentiell an, wie dies auch in Fig. 4 dargestellt ist. Der Operationsverstärker OP (Fig. 3b) erzeugt ausgangsseitig ein Einschaltsignal, solange die Versorgungsspannung Vcc niedriger als die Bezugsspannung Vref ist, wie dies auch in Fig. 5 dargestellt ist. Während des Vorliegens des Einschaltsignales ist die zweite Steuerschaltung 33 aktiv geschaltet. Der erste und zweite Transistor Q1, Q2 werden mit dem gleichen Strom von der ersten Stromspiegelschaltung 36 versorgt. Das Potential am Emitter des dritten Transistors Q3 folgt daher dem Potential an der Basis des ersten Transistros Q1 mit einer Potentialdifferenz, die sich aus dem Produkt des Widerstandswertes des vierten Widerstandes R4 und dem halben Strom der ersten Stromquelle I1 ergibt. Damit ist die Spannung am zweiten Kondensator 32 und somit am Punkt B während der Zeitdauer des Einschaltsignales um eine feste Spannungsdifferenz oberhalb der Spannung am Punkt A oder am ersten Kondensator 29, der durch die Größe des Widerstandswertes des vierten Widerstandes R4 einstellbar ist. Dieser sich während der Einschaltzeitdauer ergebende Spannungsverlauf ist auch in Fig. 6 gezeigt.

Nach dem Ausschalten des Einschaltsignales wird die zweite Steuerschaltung 33 passiv. Die Regelung der Ladung des zweiten Kondensators 32 in Abhängigkeit von der Spannung über den ersten Kondensator 29 erfolgt nun ausschließlich über die dritte Steuerschaltung 35. Die Arbeitsweise des vierten und fünften Transistors Q4, Q5 in Verbindung mit der zweiten Stromspiegelschaltung 37 und der zweiten Stromquelle I2 entspricht der Arbeitsweise der zweiten Steuerschaltung 33, so daß auf eine Erläuterung verzichtet werden kann. Wenn das Potential an der Basis des vierten Transistors Q4 höher als das an der Basis des fünften Transistors Q5 ist, bleibt der sechste Transistor Q6 ausgeschaltet, wobei der zweite Kondensator 32 über den hochohmigen Widerstand R2 sehr langsam aufgeladen wird. Zweckmäßige Zeitkonstanten liegen in der Größenordnung von mehreren Sekunden. Wenn jedoch die Spannung am Punkt A diejenige am Punkt B unterschreitet, wird der sechste Transistor Q6 durchgeschaltet, so daß der zweite Kondensator 32 schnell entladen wird, bis sich wiederum ein Gleichgewichtszustand einstellt, bei dem das Potential am

Punkt B um die durch den fünften Widerstand R5 festgelegte Differenzspannung oberhalb des Potentiales am Punkt A liegt.

Bei einem Einschalten der Gesamtschaltung stellt sich somit ein von der Kapazität der sekundärseitigen Anschlußleitungen 12, 13 abhängiger Spannungswert an dem ersten Kondensator 29 ein, der abgesehen von einer festen vorgegebenen Spannungsdifferenz während der Einschaltzeitdauer vom zweiten Kondensator 32 übernommen wird. Wenn nun nach Ablauf der Einschaltzeitdauer eine Bedienungsperson eine der Anschlußleitungen 12, 13 berührt, führt dies zu einer Erhöhung der Eingangs welchselspannung am Eingang 27 und somit zu einem schnellen Ansteigen der Spannung am ersten Kondensator 29 wegen des niederohmigen dritten Widerstandes R3, der durch den dritten Transistor Q3 gegen den ersten Kondensator 29 geschaltet wird. Die Spannung am zweiten Kondensator 32 kann nun nicht mehr folgen, da das Einschaltsignal fehlt bzw. folgt langsam über den hochohmigen zweiten Widerstand R2. Wenn die Spannung über den ersten Kondensator 29 diejenige über den zweiten Kondensator 32 übersteigt, sperrt der neunte Transistor Q9 und leitet der zehnte Transistor Q10, so daß der elfte Transistor Q11 durchschaltet und den Ausgang 28 aktiviert. Entsprechend der Berührdauer der sekundärseitigen Anschlußleitungen 12, 13 ist die Schaltdauer am Ausgang 28, die durch ein Zeitfenster innerhalb des an sich bekannten Lampenschalt- und Dimmschaltkreises 21 unterschieden wird, so daß bei kurzer Berührung ein Lampenschaltvorgang und bei längerer Berührung ein periodisches Aufwärts- und Abwärtsdimmen durch diesen Schaltkreis 21 durchgeführt werden kann.

Bei extrem guter Leitfähigkeit der Bedienungsperson BP entsteht ein sehr hohes Eingangsbrummsignal, daß zu einer so hohen Aufladung des ersten Kondensators 29 führen könnte, daß dieser Kondensator bei einem kurzen Antippen der sekundärseitigen Anschlußleitung 12 oder 13 nicht innerhalb des Zeitfensters des Lampenschalt- und Dimmschaltkreises entladen wäre. Um dies zu verhindern, wird der Maximalpotentialwert des Punktes A durch den zwölften Transistor Q12 auf einen Wert begrenzt, der um 0,7 Volt oberhalb des Potentiales am Punkt B liegt.

## Patentansprüche

1. Schaltung zum Betreiben einer über einen Transformator angeschlossenen Niederspannungslampe und zum Ein/Aus-Schalten und/oder Dimmen derselben, welche auf eine kurzfristige oder längerfristige Amplitudenveränderung einer Eingangsbrummspannung anspricht, die durch kurzfristiges oder längerfristiges Berühren der Anschlußleitung zum Ein/Aus-Schalten oder Dimmen erzeugbar ist,
die folgende Merkmale aufweist:
- einen ersten Kondensator (29), der über eine erste Steuerschaltung (30) auf eine von dem jeweiligen Spitzenwert der Eingangsbrummspannung (VIN) abhängige erste Kondensatorspannung aufladbar ist,
- eine Einschaltsignalerzeugungsschaltung (31) zum Erzeugen eines Einschaltsignales während einer bestimmten Zeitdauer ab Einschalten der Versorgungsspannung (Vcc) der Niedervoltlampe (14),
- einen zweiten Kondensator (32), der über
- eine zweite Steuerschaltung (33) angeschlossen ist, die auf das Einschaltsignal anspricht und die den zweiten Kondensator (32) bei Vorliegen des Einschaltsignales auf eine von der ersten Kondensatorspannung abhängige zweite Kondensatorspannung auflädt,
- eine erste Vergleicherschaltung (34), die eingangsseitig mit dem ersten und zweiten Kondensator (29, 32) und ausgangsseitig mit der Lampensteuerschaltung (21) in Wirkverbindung steht und die der Lampensteuerschaltung ein das Schalten oder Dimmen der Niedervoltlampe (14) bewirkendes Signal zuführt, wenn die erste Kondensatorspannung einen von der zweiten Kondensatorspannung abhängigen Spannungswert überschreitet, und
- eine dritte Steuerschaltung (35) zum Regeln der Ladung des zweiten Kondensators (32), die mit dem ersten Kondensator (29) und dem zweiten Kondensator (32) verbunden ist und die derart auf die erste und die zweite Kondensatorspannung anspricht, daß sie den zweiten Kondensator (32) entlädt, wenn die zweite Kondensatorspannung die erste Kondensatorspannung um mehr als einen vorgegebenen Differenzspannungswert übersteigt, und die anderenfalls den zweiten Kondensator (32) mit einer großen Zeitkonstante auflädt.

2. Schaltung nach Anspruch 1,
dadurch gekennzeichnet,
daß die Einschaltsignalerzeugungsschaltung (31) eine zweite Vergleicherschaltung (OP) umfaßt, die eingangsseitig mit der Versorgungsspannung versorgt wird und mit einer Bezugsspannungsquelle (Vref) in Verbindung steht und ein Ausgangssignal erzeugt, solange die Bezugsspannung (Vref) größer als die Versorgungsspannung (Vcc) ist.

3. Schaltung nach Anspruch 1 oder 2,
dadurch gekennzeichnet,
daß die zweite Steuerschaltung (33) einen ersten und einen zweiten Transistor (Q1, Q2) aufweist, die kollektorseitig mit einer ersten Stromspiegelschaltung (36) verbunden sind,
daß der erste und zweite Transistor (Q1, Q2) emitterseitig mit einem gemeinsamen ersten Knoten in Verbindung stehen, an den eine erste Stromquelle (I1) in Abhängigkeit von dem Einschaltsignal der Einschaltsignalerzeugungsschaltung (31) anschaltbar ist,
daß der erste Transistor (Q1) basisseitig an den ersten Kondensator (29) und der zweite Transistor (Q2) basisseitig an den zweiten Kondensator (32) angeschlossen sind, und
daß die zweite Steuerschaltung (33) einen dritten Transistor (Q3) aufweist, dessen Basis mit dem Kollektor des zweiten Transistors (Q2), dessen Emitter mit der Basis des zweiten Transistors (Q2) und dessen Kollektor über einen ersten Widerstand (R1) mit der Versorgungsspannung (Vcc) in Verbindung stehen.

4. Schaltung nach einem der Ansprüche 1 - 3,
dadurch gekennzeichnet,
daß die dritte Steuerschaltung (35) einen vierten und fünften Transistor (Q4, Q5) aufweist, die kollektorseitig mit einer zweiten Stromspiegelschaltung (37) verbunden sind,
daß der vierte und fünfte Transistor (Q4, Q5) mit einem gemeinsamen zweiten Knoten in Verbindung stehen, an den eine zweite Stromquelle (12) angeschlossen ist,
daß der vierte Transistor (Q4) basisseitig an den ersten Kondensator (29) und der fünfte Transistor (Q5) basisseitig an den zweiten Kondensator (32) angeschlossen sind, und
daß die dritte Steuerschaltung (35) ferner einen sechsten Transistor (Q6) aufweist, dessen Basis mit dem Kollektor des fünften Transistors (Q5), dessen Emitter mit der Basis des fünften Transistors (Q5) und dessen Kollektor mit Masse verbunden sind.

5. Schaltung nach Anspruch 4,
dadurch gekennzeichnet,
daß die dritte Steuerschaltung (35) ferner einen zweiten Widerstand (R2) aufweist, der zwischen der Versorgungsspannung (Vcc) und der Basis des fünften Transistors (Q5) geschaltet ist und einen gegenüber dem Widerstandswert des ersten Widerstandes (R1) hohen Widerstandswert hat.

6. Schaltung nach einem der Ansprüche 1 - 5,
dadurch gekennzeichnet,
daß die erste Steuerschaltung (30) einen siebten Transistor (Q7) aufweist, dem basisseitig die Eingangsbrummspannung (VIN) zuführbar ist, der kollektorseitig mit Masse verbunden ist und emitterseitig über eine Diode (39) an die Basis eines achten Transistors (Q8) der ersten Steuerschaltung (30) sowie eine dritte Stromquelle (I3) angeschlossen ist, und
daß der Kollektor des achten Transistors (Q8) über einen dritten Widerstand (R3) mit der Versorgunsspannung (Vcc) und dessen Emitter mit dem ersten Kondensator (29) verbunden sind.

7. Schaltung nach einem der Ansprüche 1 - 6,
dadurch gekennzeichnet,
daß die erste Vergleicherschaltung (34) einen neunten Transistor (Q9), der basisseitig mit dem ersten Kondensator (29), kollektorseitig mit Masse und emitterseitig mit einer vierten Stromquelle (I4) verbunden ist,
einen zehnten Transistor (Q10), der basisseitig mit dem zweiten Kondensator (32), emitterseitig mit der vierten Stromquelle (I4) und kollektorseitig über einen vierten Widerstand (R4) mit Masse verbunden ist, und
einen elften Transistor (Q11) aufweist, der basisseitig an den Kollektor des zehnten Transistors (Q10), emitterseitig mit Masse und kollektorseitig mit dem Eingang der Lampensteuerschaltung (21) verbunden ist.

8. Schaltung nach Anspruch 3 und 4,
dadurch gekennzeichnet,
daß ein vierter Widerstand (R4) zwischen dem Emitter des zweiten Transistors (Q2) und dem ersten Knoten, an dem die erste Stromquelle (I1) geschaltet ist, liegt,
daß ein fünfter Widerstamd (R5) zwischen dem Emitter des vierten Transistors (Q4) und dem zweiten Knoten, an den die zweite Stromquelle (I2) geschaltet ist, liegt, und
daß der Widerstandswert des fünften Widerstandes (R5) demjenigen des vierten Widerstandes (R4) gleicht.

9. Schaltung nach einem der Ansprüche 6 - 8,
dadurch gekennzeichnet,
daß ein Zwölfter Transistor (Q12) emitterseitig an den Emitter des siebten Transistors (Q7), basisseitig an den zweiten Kondensator (32) und kollektorseitig an Masse angeschlossen ist.

## Claims

1. A circuit for operating a low-voltage lamp, which is connected via a transformer, and for switching said lamp on/off and/or dimming it, said circuit responding to a short-term or long-term amplitude variation of an input ripple voltage, which is adapted to be produced by short-term or long-term touching of the connecting lead for on/off switching or dimming,
and having the following features:
- a first capacitor (29), which is adapted to be charged via a first control circuit (30) to a first capacitor voltage depending on the respective peak value of the input ripple voltage (VIN),
- a switch-on signal generation circuit (31) for producing a switch-on signal for a predetermined period of time from the moment at which the supply voltage (Vcc) of the low-voltage lamp (14) has been switched on,
- a second capacitor (32) connected via
- a second control circuit (33), which responds to the switch-on signal and which, when said switch-on signal is present, charges said second capacitor (23) to a second capacitor voltage depending on the first capacitor voltage,
- a first comparator circuit (34) whose input side is operatively connected to said first and second capacitors (29, 32) and whose output side is operatively connected to the lamp control circuit (21), said first comparator circuit supplying to said lamp control circuit a signal, which effects switching or dimming of said low-voltage lamp (14), if said first capacitor voltage exceeds a voltage value depending on the second capacitor voltage, and
- a third control circuit (35) used for controlling the charge of the second capacitor (32) and connected to said first capacitor (29) and to said second capacitor (32), said third control circuit (35) responding to said first and second capacitor voltages such that it will discharge the second capcitor (32), if the second capacitor voltage exceeds the first capacitor voltage by more than a predetermined differential voltage value, whereas, if this is not the case, it will charge the second capacitor (32) with a large time constant.

2. A circuit according to claim 1,
characterized in
that the switch-on signal generation circuit (31) includes a second comparator circuit (OP), which has supplied thereto the supply voltage on its input side and which is connected to a reference voltage source (Vref), said second comparator circuit (OP) producing an output signal as long as the reference voltage (Vref) exceeds the supply voltage (Vcc).

3. A circuit according to claim 1 or 2,
characterized in
that the second control circuit (33) is provided with first and second transistors (Q1, Q2), which are connected to a first current mirror circuit (36) on their collector side,
that the emitter sides of said first and second transistors (Q1, Q2) are connected to a common first junction, which is adapted to have connected thereto a first current source (I1) in response to the switch-on signal of the switch-on signal generation circuit (31),
that the base side of the first transistor (Q1) is connected to the first capacitor (29) and that the base side of the second transistor (Q2) is connected to the second capacitor (32), and
that the second control circuit (33) is provided with a third transistor (Q3) whose base is connected to the collector of the second transistor (Q2), whose emitter is connected to the base of the second transistor (Q2) and whose collector is connected to the supply voltage (Vcc) via a first resistor (R1).

4. A circuit according to one of the claims 1 to 3,
characterized in
that the third control circuit (35) is provided with fourth and fifth transistors (Q4, Q5), which are connected to a second current mirror circuit (37) on their collector side,
that the fourth and fifth transistors (Q4, Q5) are connected to a common second junction having connected thereto a second current source (I2),
that the base side of the fourth transistor (Q4) is connected to the first capacitor (29) and that the base side of the fifth transistor (Q5) is connected to the second capacitor (32), and
that the third control circuit (35) is additionally provided with a sixth transistor (Q6) whose base is connected to the collector of the fifth transistor (Q5), whose emitter is connected to the base of the fifth transistor (Q5) and whose collector is connected to ground.

5. A circuit according to claim 4,
characterized in
that the third control circuit (35) is additionally provided with a second resistor (R2), which is connected between the supply voltage (Vcc) and the base of the fifth transistor (Q5) and the resistance value of which is high in comparison with the resistance value of the first resistor (R1).

6. A circuit according to one of the claims 1 to 5,
characterized in
that the first control circuit (30) is provided with a seventh transistor (Q7), which is adapted to have supplied thereto the input ripple voltage (VIN) on its base side, which is connected to ground on its collector side, and which, on its emitter side, is connected via a diode (39) to the base of an eighth transistor (Q8) of the first control circuit (30) as well as to a third current source (I3), and
that the collector of said eighth transistor (Q8) is connected via a third resistor (R3) to the supply voltage (Vcc), whereas the emitter thereof is connected to the first capacitor (29).

7. A circuit according to one of the claims 1 to 6,
characterized in
that the first comparator circuit (34) comprises
a ninth transistor (Q9) having its base side connected to the first capacitor (29), its collector side connected to ground, and its emitter side connected to a fourth current source (I4),
a tenth transistor (Q10) having its base side connected to the second capacitor (32), its emitter side connected to the fourth current source (I4), and its collector side connected to ground via a fourth resistor (R4), and
an eleventh transistor (Q11) having its base side connected to the collector of the tenth transistor (Q10), its emitter side connected to ground, and its collector side connected to the input of the lamp control circuit (21).

8. A circuit according to claims 3 and 4,
characterized in
that a fourth resistor (R4) is disposed between the emitter of the second transistor (Q2) and the first junction, which has connected thereto the first current source (I1),
that a fifth resistor (R5) is disposed between the emitter of the fourth transistor (Q4) and the second junction, which has connected thereto the second currrent source (I2), and
that the resistance value of the fifth resistor (R5) corresponds to that of the fourth resistor (R4).

9. A circuit according to one of the claims 6 to 8,
characterized in
that a twelfth transistor (Q12) has its emitter side connected to the emitter of the seventh transistor (Q7), its base side connected to the second capacitor (32), and its collector side connected to ground.

## Revendications

1. Circuit pour le fonctionnement d'une lampe à basse tension raccordée par l'intermédiaire d'un transformateur et destiné à l'allumage/l'extinction et/ou au réglage de l'intensité de celle-ci, qui réagit à un changement d'amplitude d'une tension alternative d'entrée de courte ou de plus longue durée pouvant être produit par un contact de courte ou de plus longue durée de la ligne de raccordement en vue de l'allumage/l'extinction ou du réglage d'intensité, qui présente les caractéristiques suivantes:
- un premier condensateur (29) qui peut être chargé, par un premier circuit de commande (30), à une première tension de condensateur fonction de la valeur de pointe respective de la tension de ronflement d'entrée (VIN),
- un circuit générateur de signaux d'enclenchement (31) destiné à engendrer un signal d'enclenchement pendant un laps de temps déterminé à partir de l'enclenchement de la tension d'alimentation (Vcc) de la lampe à basse tension (14),
- un second condensateur (32) qui est raccordé par
- un second circuit de commande (33) qui réagit au signal d'enclenchement et qui charge le second condensateur (32), en cas de présence du signal d'enclenchement, à une seconde tension de condensateur fonction de la première tension de condensateur,
- un premier circuit comparateur (34) qui est relié en fonctionnement, du côté entrée, au premier et au second condensateur (29, 32) et, du côté sortie, au circuit de commande de lampe (21) et qui envoit au circuit de commande de lampe un signal provoquant la commutation ou le réglage d'intensité de la lampe à basse tension (14) lorsque la première tension de condensateur excède une valeur de tension fonction de la seconde tension de condensateur, et
- un troisième circuit de commande (35) destiné à régler le chargement du second condensateur (32), qui est relié au premier condensateur (29) et au second condensateur (32) et qui réagit aux première et seconde tensions de condensateur de telle manière qu'il décharge le second condensateur (32) lorsque la seconde tension de condensateur excède la première tension de condensateur de plus d'une valeur de tension différentielle prédéterminée et qui, dans le cas contraire, charge le second condensateur (32) avec une grande constante de temps.

2. Circuit suivant la revendication 1, caractérisé en ce que le circuit générateur de signaux d'enclenchement (31) comprend un second circuit comparateur (OP) qui est alimenté, du côté entrée, par la tension d'alimentation et est relié à une source de tension de référence (Vref) et engendre un signal de sortie tant que la tension de référence (Vref) est supérieure à la tension d'alimentation (Vcc).

3. Circuit suivant la revendication 1 ou 2, caractérisé en ce que le second circuit de commande (33) présente un premier et un second transistor (Q1, Q2) qui sont reliés, du côté du collecteur, à un premier circuit-miroir de courant (36),
que les premier et second transistors (Q1, Q2) sont reliés, du côté de l'émetteur, à un premier noeud commun auquel peut être raccordée, en fonction du signal d'enclenchement du circuit générateur de signaux d'enclenchement (31), une première source de courant (I1), que le premier transistor (Q1) est raccordé, du côté de la base, au premier condensateur (29) et le second transistor (Q2) est raccordé, du côté de la base, au second condensateur (32), et
que le second circuit de commande (33) présente un troisième transistor (Q3) dont la base est reliée au collecteur du second transistor (Q2), dont l'émetteur est relié à la base du second transistor (Q2) et dont le collecteur est relié, par une première résistance (R1), à la tension d'alimentation (Vcc).

4. Circuit suivant l'une des revendications 1 à 3, caractérisé en ce
que le troisième circuit de commande (35) présente un quatrième et un cinquième transistor (Q4, Q5) qui sont reliés, du côté du collecteur, à un second circuit-image de courant (37),
que les quatrième et cinquième transistors (Q4, Q5) sont reliés à un second noeud commun auquel est raccordée une seconde source de courant (I2),
que le quatrième transistor (Q4) est raccordé, du côté de la base, au premier condensateur (29) et que le cinquième transistor (Q5) est racordé, du côté de la base, au second condensateur (32), et
que le troisième circuit de commande (35) présente, par ailleurs, un sixième transistor (Q6) dont la base est reliée au collecteur du cinquième transistor (Q5), dont l'émetteur est relié à la base du cinquième transistor (Q5) et dont le collecteur est relié à la masse.

5. Circuit suivant la revendication 4, caractérisé en ce que le troisième circuit de commande (35) présente, par ailleurs, une seconde résistence (R2) qui est installée entre la tension d'alimentation (Vcc) et la base du cinquième transistor (Q5) et présente, par rapport à la valeur de résistance de la première résistance (R1), une valeur de résistance élevée.

6. Circuit suivant l'une des revendications 1 à 5, caractérisée en ce
que le premier circuit de commande (30) présente un septième transistor (Q7) auquel peut être amené, du côté de la base, la tension de ronflement d'entrée (VIN) et qui est relié, du côté du collecteur, à la masse et qui est raccordé, du côté de l'émetteur, par une diode (39), à la base d'un huitième transistor (Q8) du premier circuit de commande (30) ainsi qu'à une troisième source de courant (I3), et
que le collecteur du huitième transistor (Q8) est relié, par une troisième résistance (R3), à la tension d'alimentation (Vcc) et son émetteur au premier condensateur (29).

7. Circuit suivant l'une des revendications 1 à 6, caractérisé en ce que le premier circuit comparateur (34) présente
un neuvième transistor (Q9) qui est relié, du côté de la base, au premier condensateur (29), du côté du collecteur, à la masse et, du côté de l'émetteur, à une quatrième source de courant (I4),
un dixième transistor (Q10) qui est relié, du côté de la base, au second condensateur (32), du côté de l'émetteur, à la quatrième source de courant (I4) et, du côté du collecteur, par une quatrième résistance, à la masse, et
un onzième transistor (Q11) qui est relié, du côté de la base, au collecteur du dixième transistor (Q10), du côté de l'émetteur, à la masse et, du côté du collecteur, à l'entrée du circuit de commande de lampe (21).

8. Circuit suivant les revendications 3 et 4, caractérisé en ce qu'une quatrième résistance (R4) se trouve entre l'émetteur du second transistor (Q2) et le premier noeud auquel est raccordée la première source de courant (I1),
qu'une cinquième résistance (R5) se trouve entre l'émetteur du quatrième transistor (Q4) et le second noeud auquel est raccordée la seconde source de courant (I2),
que la valeur de résistance de la cinquième résistance (R5) est égale à celle de la quatrième résistance (R4).

9. Circuit suivant l'une des revendications 6 à 8, caractérisée en ce qu'un douzième transistor (Q12) est raccordé, du côté de l'émetteur, à l'émetteur du septième transistor (Q7), du côté de la base, au second condensateur (32) et, du côté du collecteur, à la masse.
